# EUROPEAN PATENT APPLICATION

(11) **EP 4 806 623 A1**
(43) Date of publication of application: **16.09.2026**
(21) Application number: 26164110.4
(22) Date of filing: 11.03.2026
(51) Int. Cl.: B29C 70/88, B05D 1/00

(54) **LIGHTNING STRIKE PROTECTION SKIN**

(30) Priority: 11.03.2025 US 202563769937 P
(71) Applicant: Rohr, Inc., Chula Vista, CA 91910-2098 (US)
(72) Inventor: SHEN, Shyan Bob, San Diego, 92126 (US); CROSHAW, Chris, San Diego, 92110 (US); URSENBACH, Daniel O., El Cajon, 92109 (US); VAN TOOREN, Michael, San Diego, 92122 (US); STEIDEL, Kourtney, Bury St Edmunds, IP33 3PQ (GB); ZIMMERMANN, Natalie, Orange, 92868 (US)
(74) Representative: Dehns

(57) **Abstract**

A formation method is provided. During the method, a thermoplastic composite (TPC) skin and a lightning strike protection (LSP) layer are provided (502, 504). The TPC skin is arranged (506) with the LSP layer on a tool to provide a material stack, and the material stack is consolidated (508) to form a consolidated TPC structure. A thin film (TF) layer on the consolidated TPC structure using a plasma treatment process (510). The LSP layer may be configured as or otherwise include LSP material, and the TF layer may include a TF material configured as or otherwise including an amine functional group or an epoxy functional group.

## Description

### BACKGROUND

### 1. Technical Field

This disclosure relates generally to lightning strike protection and, more particularly, to providing an aircraft component with lightning strike protection.

### 2. Background Information

Various methods are known in the art for providing a thermoplastic composite aircraft component with lightning strike protection. While these known methods have various benefits, there is still room in the art for improvement.

### SUMMARY OF THE DISCLOSURE

According to an aspect of the present disclosure, a formation method is provided. During the method, a thermoplastic composite (TPC) skin and a lightning strike protection (LSP) layer are provided. The TPC skin is arranged with the LSP layer on a tool to provide a material stack, and the material stack is consolidated to form a consolidated TPC structure. A thin film (TF) layer on the consolidated TPC structure using a plasma treatment process. The LSP layer may be configured as or otherwise include LSP material, and the TF layer may include a TF material configured as or otherwise including an amine functional group or an epoxy functional group.

In any of the aspects and/or embodiments described above or herein, the TPC skin may be configured as or otherwise include thermoplastic material and fiber reinforcement embedded within the thermoplastic material of the TPC skin.

In any of the aspects and/or embodiments described above or herein, the LSP layer may be configured as or otherwise include the LSP material embedded within a thermoplastic matrix.

In any of the aspects and/or embodiments described above or herein, the LSP material may be configured as or otherwise include a metal foil or a metal mesh.

In any of the aspects and/or embodiments described above or herein, the LSP layer may be configured as or otherwise include second thermoplastic material. The LSP material may be configured as or otherwise include a plurality of interconnected conductive elements embedded within the second thermoplastic material.

In any of the aspects and/or embodiments described above or herein, the consolidated TPC structure may be configured as or otherwise include the LSP layer bonded to the TPC skin.

In any of the aspects and/or embodiments described above or herein, the deposited TF layer may increase a surface energy of the consolidated TPC structure.

In any of the aspects and/or embodiments described above or herein, the TF material may further comprise silicon.

In any of the aspects and/or embodiments described above or herein, the TF material may further comprise an epoxy, an epoxy functional siloxane and/or an amine functional siloxane.

In any of the aspects and/or embodiments described above or herein, the TF material may consist of glycidyl methacrylate, N,N-Digylcidyl-4-glycidyloxyaniline, N-(3-Trimethoxysilylpropyl) diethylenetriamine, and/or (3-Aminopropyl) triethoxysilane.

In any of the aspects and/or embodiments described above or herein, depositing the TF layer on the consolidated TPC structure using the plasma treatment process may further comprise arranging the consolidated TPC structure within a plasma treatment chamber, introducing gaseous TF material into the plasma treatment chamber and ionizing the gaseous TF material to bond the TF material onto the consolidated TPC structure.

In any of the aspects and/or embodiments described above or herein, the ionizing the gaseous TF material may comprise applying an energy source to the plasma treatment chamber.

In any of the aspects and/or embodiments described above or herein, the method may further comprise providing a resin film layer and arranging the resin film layer on the LSP layer to provide the material stack. The LSP layer may be arranged vertically between TPC layer and the resin film layer.

In any of the aspects and/or embodiments described above or herein, the method may further comprise applying a paint layer on the TF layer to provide an aircraft component.

In any of the aspects and/or embodiments described above or herein, the consolidated TPC structure may include the LSP layer arranged over the TPC skin. The TF layer may be deposited over the LSP layer with the LSP layer between the TF layer and the TPC skin.

According to an aspect of the present disclosure, a method of forming an aircraft component is provided. During the method, a thermoplastic composite (TPC) skin, a lightning strike protection (LSP) material, and a resin film layer is provided. The TPC skin is arranged on a tool and the LSP material is deposited onto the TPC skin. The resin film layer is deposited on the LSP layer to form a material stack with the LSP material between the TPC skin and the resin film layer. The material stack is consolidated to provide a consolidated TPC structure. A thin film (TF) layer is deposited on the consolidated TPC structure using a plasma treatment process. The TF layer includes a TF material which may comprise an epoxy, an epoxy functional siloxane and/or an amine functional siloxane.

In any of the aspects and/or embodiments described above or herein, depositing the thin film layer on the consolidated TPC structure using the plasma treatment process may further comprise arranging the consolidated TPC structure within a vacuum chamber, introducing gaseous TF material into the vacuum chamber and ionizing the gaseous TF material using an energy source to bond the TF material onto the consolidated TPC structure.

In any of the aspects and/or embodiments described above or herein, the deposited TF layer increases a wettability of the consolidated TPC structure.

In any of the aspects and/or embodiments described above or herein, the method may further include applying a paint layer on the TF layer to provide the aircraft component.

According to an aspect of the present disclosure, a formation method is provided. During the method, a thermoplastic composite (TPC) skin and a lightning strike protection (LSP) material are provided. The LSP material may be configured as or otherwise include metal mesh and/or metal foil. The TPC skin is arranged with the LSP material to provide a material stack. The material stack is consolidated to provide a consolidated TPC structure. The consolidated TPC structure is arranged within a plasma treatment chamber, and gaseous TF material is introduced into the plasma treatment chamber. This gaseous TF material is ionized using an energy source to bond TF material onto the consolidated TPC structure. The TF material may be configured as or otherwise include an amine functional group with silicon and/or an epoxy functional group. A paint layer is applied on the consolidated TPC structure with the bonded TF material to form an aircraft component.

The foregoing features and elements may be combined in various combinations without exclusivity, unless expressly indicated otherwise. For example, aspects and/or embodiments of the present disclosure may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

FIG. 1 is a schematic illustration of an aircraft according to an embodiment of the present disclosure.
FIG. 2 is a partial sectional illustration of an aircraft component with a thermoplastic composite skin and a lightning strike protection layer according to an embodiment of the present disclosure.
FIG. 2A is a partial sectional illustration of an aircraft component with a thermoplastic composite skin and a lightning strike protection layer according to an embodiment of the present disclosure.
FIGS. 3 is a partial closeup illustration of layers forming the aircraft component including a lightning strike protection layer according to an embodiment of the present disclosure.
FIGS. 4 is a partial plan view illustration of lightning strike protection mesh.
FIG. 5 is a flow diagram of a method for forming an aircraft component according to an embodiment of the present disclosure.
FIG. 6A-E are illustrations depicting a sequence of steps for forming the aircraft component according to an embodiment of the present disclosure.
FIG. 7A-D are illustrations depicting a sequence of steps for forming the aircraft component according to an embodiment of the present disclosure.
FIG. 8 is a partial sectional illustration of a painted aircraft component according to an embodiment of the present disclosure.

### DETAILED DESCRIPTION

The present disclosure includes methods for forming a thermoplastic composite component of an aircraft with integrated lightning strike protection. Briefly, thermoplastic materials typically have low surface energy and consequently relatively poor paint adhesion. The relatively poor paint adhesion can lead to cosmetic issues such as paint peeling and cracking. The poor paint adhesion is particularly an issue when the thermoplastic material is subject to a lightning strike. The present disclosure addresses these shortcomings.

The term "forming" may describe a method for original manufacture of the aircraft component; e.g., creating a brand new aircraft component. The term "forming" may also or alternatively describe a method for remanufacture or otherwise repairing of the aircraft component; e.g., restoring one or more features of a previously formed aircraft component to brand new condition, similar to brand new condition, better than brand new condition, etc.

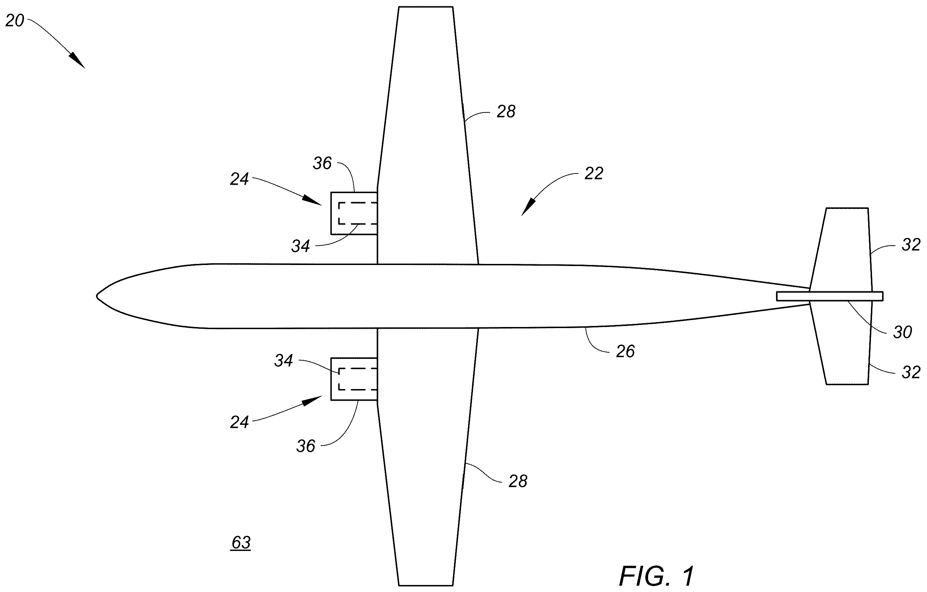

The aircraft may be an airplane, a helicopter, a drone (e.g., an unmanned aerial vehicle (UAV)), a missile, a rocket, or any other manned or unmanned aerial or aerospace vehicle or system. However, for ease of description, the aircraft may be generally described below as an airplane. An exemplary embodiment of such an aircraft 20 is shown in FIG. 1. This aircraft 20 includes an airframe 22 and one or more propulsion systems 24. The aircraft airframe 22 of FIG. 1 includes a fuselage 26, one or more wings 28, and one or more stabilizers 30 and 32. Each aircraft propulsion system 24 may include a power unit 34 partially or completely housed within a nacelle 36. Examples of the power unit 34 include, but are not limited to, a turbofan engine, a turboprop engine, a turbojet engine, a turboshaft engine, a rotary engine (e.g., a Wankel engine), a reciprocating piston engine, a hybrid powerplant and an electric motor.

The formation methods of the present disclosure may be used to form various aircraft components. Such an aircraft component, for example, may be configured as or otherwise included as part of the aircraft fuselage 26, one of the aircraft wings 28, the vertical aircraft stabilizer 30, one of the horizontal aircraft stabilizers 32, the propulsion system nacelle 36, or any other thermoplastic composite member of the aircraft 20 which includes lightning strike protection.

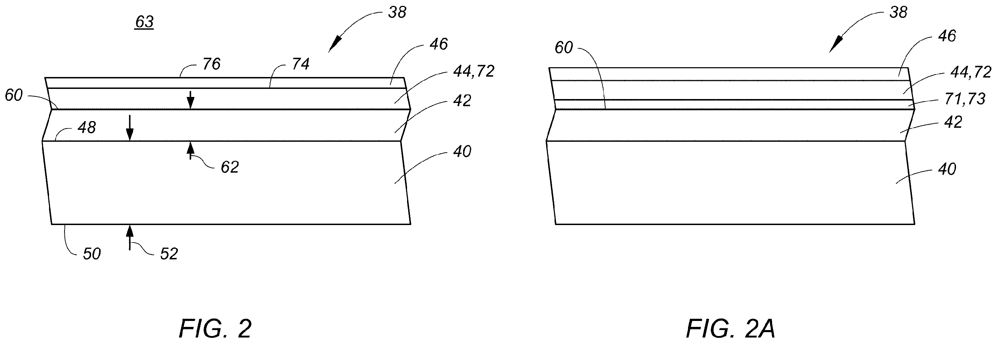

An exemplary embodiment of such an aircraft component 38 is shown in FIG. 2. This aircraft component 38 of FIG. 2 includes a thermoplastic composite (TPC) skin 40, a lightning strike protection (LSP) layer 42, a thin film (TF) layer 44 and an exterior paint layer 46. The LSP layer 42 is bonded to the TPC skin 40. The TF layer 44 is deposited to the LSP layer 42 and is configured to improve adhesion between the LSP layer 42 and the paint layer 46. The paint layer 46 of FIG. 2 may be configured with or otherwise include a primer and a topcoat.

The TPC skin 40 extends vertically between an exterior surface 48 of the TPC skin 40 and an interior surface 50 of the TPC skin 40. The TPC skin 40 extends laterally in a first direction as well as laterally in a second direction. A vertical dimension 52 of the TPC skin 40 is (e.g., significantly) smaller than a lateral first direction dimension of the TPC skin 40 and/or a lateral second direction dimension of the TPC skin 40 providing the TPC skin 40 with a generally planar (e.g., sheet-like) geometry. This skin geometry may be a curved (e.g., arcuate) geometry. For example, the vertical direction of FIG. 2 is a radial direction, the first lateral direction is an axial direction, and the second lateral direction is a circumferential direction. While the TPC skin 40 is shown in FIG. 2 as a two-dimensionally flat member of the TPC skin 40, the present disclosure is not limited thereto. For example, the TPC skin 40 may alternatively be a three-dimensionally curved member of the TPC skin 40, or alternatively a two-dimensionally curved member of the TPC skin 40.

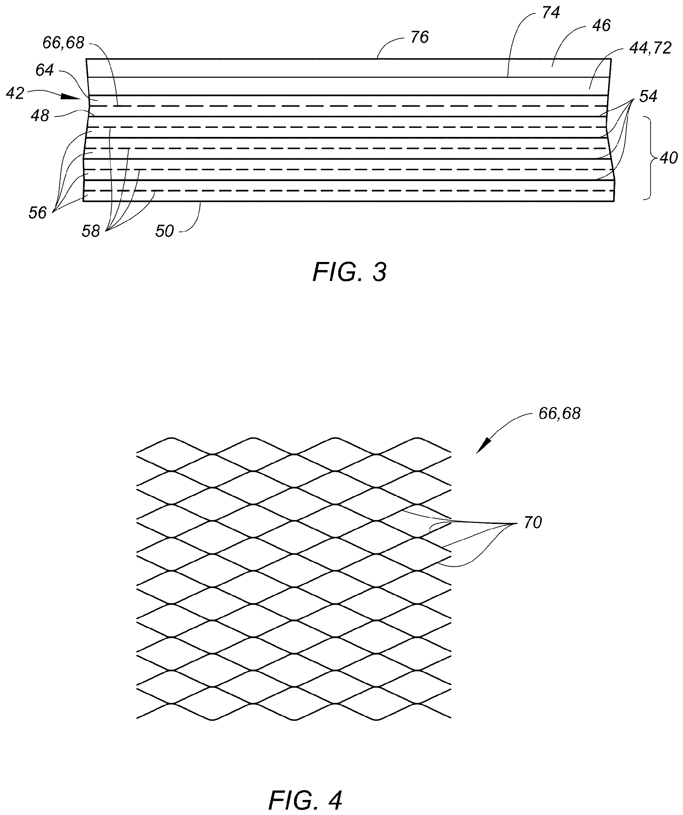

Referring to FIG. 3, the TPC skin 40 may be formed from one or more consolidated layers 54 of thermoplastic composite material. Each thermoplastic composite structure (TCS) layer 54, for example, includes a thermoplastic matrix 56 and fiber reinforcement 58 embedded within the thermoplastic matrix 56. The thermoplastic matrix 56 is a thermoplastic material (e.g., a thermoplastic resin) such as, but not limited to, thermoplastic film polyamide (PA), polyamide-imide (PAI), polyarylsulfone (PAS), polyethersulfone (PES), polyoxymethylene (POM), polyphenylene sulfide (PPS), polyether ether ketone (PEEK), polyetherimide (PEI), polyethylene terephthalate (PET), polyphthalamide (PPA), poly ether ketone ketone (PEKK), or poly aryl ether ketone (PAEK). The fiber reinforcement 58 may be or otherwise include fiberglass fibers, carbon fiber fibers, aramid (e.g., Kevlar^{®}) fibers and/or the like. This fiber reinforcement 58 may be arranged as a (e.g., unidirectional, woven or unwoven) sheet of fibers and/or chopped fibers. The present disclosure, however, is not limited to such exemplary materials nor such layered construction.

Referring to FIG. 2, the LSP layer 42 is vertically next to the TPC skin 40 at the skin exterior surface 48. The LSP layer 42 of FIG. 3, for example, is bonded directly to the TPC skin 40 at the skin exterior surface 48. Note, while the LSP layer 42 and the TPC skin 40 are schematically shown in FIG. 2 as separate members of the aircraft component 38, the LSP layer 42 may actually become an integral part of the TPC skin 40 after the LSP layer 42 is bonded to the TPC skin 40. Referring again to FIG. 2, the LSP layer 42 projects vertically out from the TPC skin 40 to an LSP exterior surface 60. Here, a vertical dimension 62 of the LSP layer 42 is smaller than the vertical dimension 52 of the TPC skin 40. The vertical dimension 52 of the TPC skin 40, for example, may be five times (5x), ten times (10x), fifteen times (15x), or more larger than the vertical dimension 62 of the LSP layer 42. The present disclosure, however, is not limited to such an exemplary dimensional relationship between the LSP layer 42 and the TPC skin 40. In other embodiments, for example, it is contemplated the vertical dimension 52 of the TPC skin 40 may be less than five times (5x) larger than the vertical dimension 62 of the LSP layer 42.

The LSP layer 42 of FIG. 2 extends laterally in the lateral first direction and in the lateral second direction along the TPC skin 40. The LSP layer 42 may thereby partially or completely cover the TPC skin 40 in the lateral first direction and/or in the lateral second direction. With this arrangement, the LSP layer 42 may provide a physical barrier as well as a lightning strike protection buffer between (a) the TPC skin 40 and (b) an environment 63 external to and adjacent to the aircraft component 38.

Referring to FIG. 3, the LSP layer 42 may be configured with or otherwise include a thermoplastic matrix 64 and lightning strike protection (LSP) material 66 embedded within (e.g., impregnated with) the thermoplastic matrix 64; e.g., without any fiber reinforcement. However, it is contemplated that the LSP layer 42 may alternatively be configured without the thermoplastic matrix in other embodiments. Referring again to FIG. 3, the thermoplastic matrix 64 is a thermoplastic material (e.g., a thermoplastic resin) such as, but not limited to, thermoplastic film polyamide (PA), polyamide-imide (PAI), polyarylsulfone (PAS), polyethersulfone (PES), polyoxymethylene (POM), polyphenylene sulfide (PPS), polyether ether ketone (PEEK), polyetherimide (PEI), polyethylene terephthalate (PET), polyphthalamide (PPA), poly ether ketone ketone (PEKK), or poly aryl ether ketone (PAEK). This thermoplastic matrix 64 / thermoplastic material of the LSP layer 42 may be the same as (or different than, but bondable with) the thermoplastic matrix 56 / thermoplastic material of the TPC skin 40. The LSP material 66 may be configured as a conductive mesh 68; e.g., a grid, a screen, a piece of expanded foil, etc. This conductive mesh 68 may be formed from metal such as copper. Referring to FIG. 4, the LSP material 66 and the conductive mesh 68 may include a plurality of interconnected conductive elements 70; e.g., struts, wires, etc. The present disclosure, however, is not limited to such exemplary materials nor such construction. For example, while the aircraft component 38 is configured with a single LSP layer 42 in FIG. 3, it is contemplated a stack of multiple LSP layers 42 may be bonded to the TPC skin 40.

Referring to FIG. 2, the TF layer is vertically next to the LSP layer 42 at the LSP exterior surface 60. The TF layer 44 of FIG. 2, for example, is deposited (e.g., applied) to the LSP layer 42 at the LSP exterior surface 60. The TF layer 44 extends laterally in the lateral first direction and in the lateral second direction along the LSP layer 42. The TF layer 44 may thereby partially or completely cover the LSP layer 42 in the lateral first direction and/or in the lateral second direction. With this arrangement, the TF layer 44 may provide a boundary layer configured to improve adhesion between (a) the LSP layer 42 and the paint layer 46 of the aircraft component 38 (See e.g., FIG. 2) and/or (b) a resin film layer 71 (See e.g., FIG 2A).

Referring to FIG. 3, the TF layer 44 includes a TF material 72. The TF material 72, for example, may comprise an organofunctional agent capable of forming an interface between an inorganic substrate and an organic material to facilitate bonding therebetween. The TF material 72 may comprise an amine functional group with silicon or an epoxy functional group. Exemplary TF materials 72 may include, but are not limited to, epoxies (e.g., glycidyl methacrylate (GLYMA), N,N-Digylcidyl-4-glycidyloxyaniline (TRIGLY)), epoxy functional siloxanes (e.g., (3-Glycidyloxypropyl) trimethoxysilane (GLYMO)), amine functional siloxanes (e.g., N-(3-Trimethoxysilylpropyl) diethylenetriamine (TRIAP) and (3-Aminopropyl) triethoxysilane (APTES)) and the like.

Referring to FIG. 2, the paint layer 46 is vertically next to the TF layer 44. The paint layer 46 of FIG. 2, for example, is deposited (e.g., applied) to a TF exterior surface 74. The paint layer 46 extends laterally in the lateral first direction and in the lateral second direction along the TF layer 44. The paint layer 46 may thereby partially or completely cover the TF layer 44 in the lateral first direction and/or in the lateral second direction. An exterior surface 76 of the paint layer 46 may be an aerodynamic exterior flow surface of the aircraft component 38 exposed to (e.g., in fluid contact with) air flowing along the aircraft component 38 during aircraft operation.

In some embodiments, referring to FIG. 2A, the aircraft component 38 may be configured with a resin film layer 71 vertically between the LSP layer 42 and the TF layer 44. The resin film layer 71 of FIG. 2A, for example, is bonded to the LSP layer 42 at the LSP exterior surface 60. The resin film layer 71 extends laterally in the lateral first direction and in the lateral second direction along the LSP layer 42. The resin film layer 71 may thereby partially or completely cover the LSP layer 42 in the lateral first direction and/or in the lateral second direction.

The resin film layer 71 of FIG. 2A includes a resin film material 73. Examples of the resin film material 73 include, but are not limited to, a semi-crystalline thermoplastic resin and an amorphous thermoplastic resin. Examples of the semi-crystalline thermoplastic resin include, but are not limited to, polyester, polyolefin, polyoxymethylene (POM), polyamide (PA), polyarylene sulfide, polyketone (PK), polyetherketone (PEK), polyether ether ketone (PEEK), polyether ketone ketone (PEKK), polyvinylidene fluoride (PVDF), polytetrafluoroethylene (PTFE), polyaryletherketone (PAEK), polyether nitrile (PEN), fluororesin, and liquid crystal polymer (LCP). Examples of the polyester include, but are not limited to, polyethylene terephthalate (PET), polybutylene terephthalate (PBT), polytrimethylene terphthalate (PTT), polyethylene naphthalate (PEN), and liquid crystal polyester. Examples of the polyolefin include, but are not limited to, polyethylene (PE), polypropylene (PP), and polybutylene. An example of the polyarylene sulfide includes, but is not limited to, polyphenylene sulfide (PPS). An example of the fluororesin includes, but is not limited to, polytetrafluoroethylene. Examples of the amorphous thermoplastic resin include, but are not limited to, polystyrene, polycarbonate (PC), polymethyl methacrylate (PMMA), polyvinyl chloride (PVC), polyphenylene ether (PPE), polyimide (PI), polyamide imide (PAI), polyetherimide (PEI), polysulfone (PSU), polyether sulfone (PES), and polyarylate (PAR). The present disclosure, however, is not limited to the foregoing exemplary resin film materials.

Referring to FIG. 2, prior to bonding the LSP layer 42 to the TPC skin 40, the TPC skin 40 may be configured as a preform of the aircraft component 38. The TPC skin 40, for example, may provide the aircraft component 38 with its general geometry; e.g., shape, dimensions, etc. The TPC skin 40 may also be self-supported and provide the aircraft component 38 with structural form and rigidity. The LSP layer 42, the TF layer 44, and/or the paint layer 46 of FIG. 2 may be included to provide the aircraft component 38 with integrated lightning strike protection and/or form the finished exterior surface of the aircraft component 38 over the TPC skin 40. That said, by effectively increasing the vertical thickness of the TPC skin 40, the LSP layer 42, the TF layer 44, and/or the resin film layer 71 of FIGS. 2 and 2A may also increase a structural integrity and/or rigidity of the TPC skin 40 and thereby the aircraft component 38. The present disclosure, however, is not limited to the foregoing exemplary aircraft component configuration or construction.

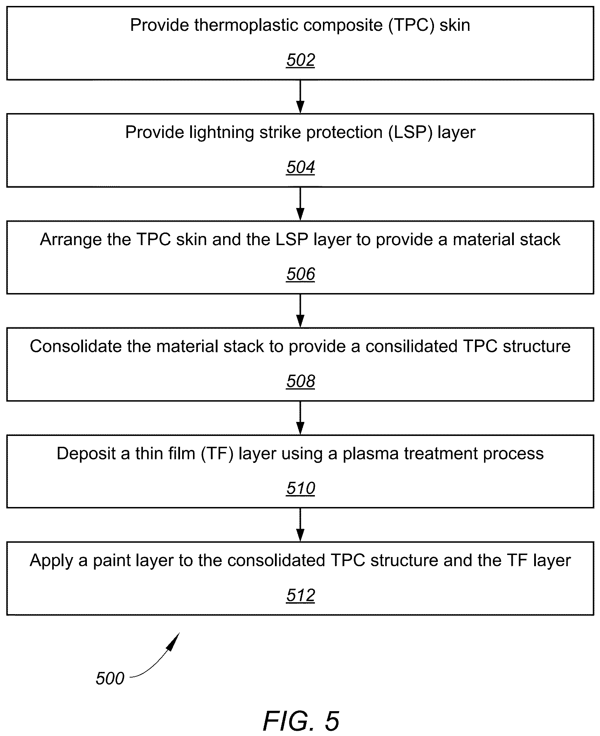

FIG. 5 is a flow diagram of a method 500 for forming a thermoplastic composite component with integrated lightning strike protection and increased adhesion with a painted layer. For ease of description, the formation method 500 is described below with respect to the aircraft component 38 of FIGS. 2 and 2A. The formation method 500 of the present disclosure, however, may alternatively be used to form various other types, geometries and/or structural configurations of aircraft components with lightning strike protection.

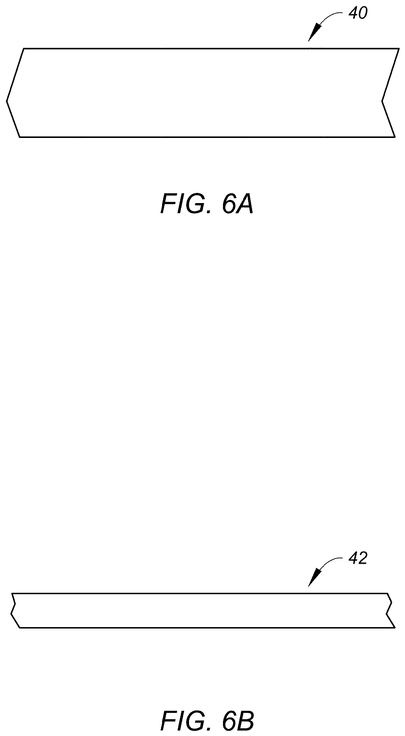

In step 502, referring to FIG. 6A, the TPC skin 40 is provided. For ease of description, the TPC skin 40 is described below as an original manufacture (e.g., brand new) thermoplastic composite structure. For example, each individual layer of the TPC skin 40 may be discretely formed; e.g., laid up and consolidated. The present disclosure, however, is not limited to such exemplary manufacturing techniques for the TPC skin 40. Moreover, it is contemplated the TPC skin 40 may alternatively be a repaired thermoplastic composite structure.

In step 504, referring to FIG. 6B, the LSP layer 42 is provided. At this step, the LSP layer 42 is discretely formed from and is not yet arranged with or bonded to the TPC skin 40. This may facilitate the formation of the LSP layer 42 as well as the TPC skin 40 using formation techniques specifically tailored to the individual construction of that aircraft component member 42, 40.

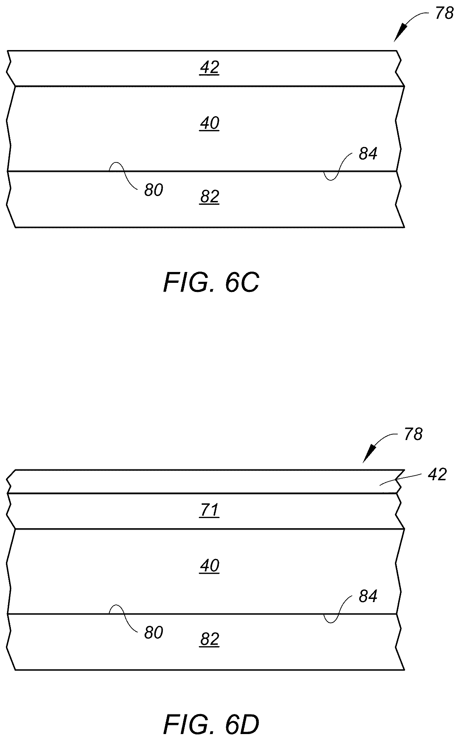

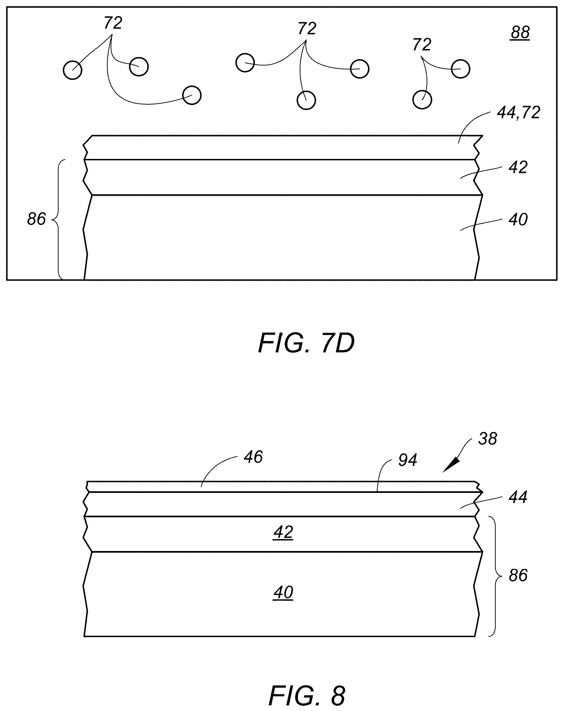

In step 506, referring to FIG. 6C, a material stack 78 is formed. The LSP layer 42, for example, is arranged with the TPC skin 40 to form the material stack 78. The TPC skin 40 of FIG. 8C is deposited on a surface 80 of a tool 82 (e.g., a mold). A skin first side 84 of the TPC skin 40, for example, may overlay and engage (e.g., abut against, fully contact, etc.) the surface 80. The surface 80 may be configured with or otherwise include a contour similar to a geometric configuration of the aircraft component 38 to be formed.

The LSP layer 42 of FIG. 6C may be deposited on the tool and the deposited TPC skin 40. The LSP layer 42 may be deposited on a skin second side of the TPC skin 40. The LSP layer 42 may thereby overlay and engage (e.g., abut against, fully contact, etc.) the TPC skin 40 at the skin second side. Optionally, referring to FIG. 6D, the resin film layer 71 may be deposited on the LSP layer 42 for form the material stack 78.

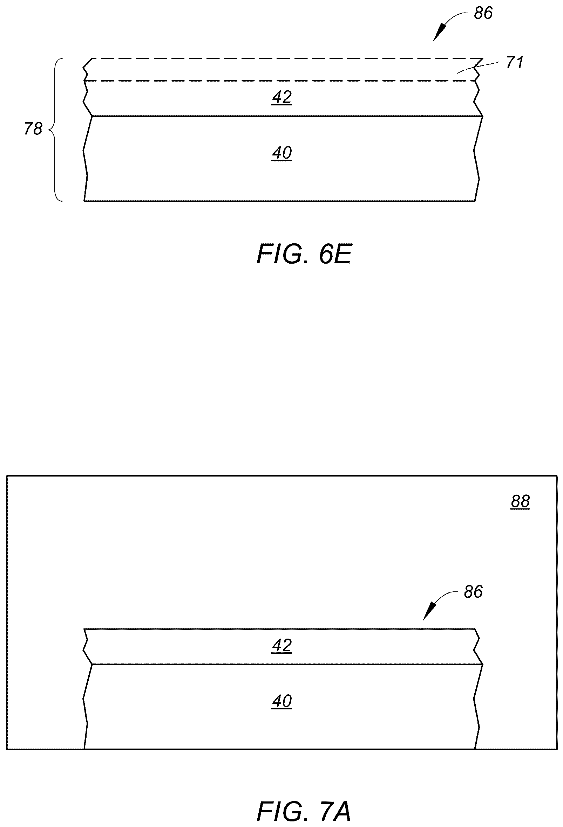

In step 508, referring to FIG. 6E, the material stack 78 is consolidated using, for example, a mold press, vacuum bag, and the like. The material stack 78 may then be heated, for example, in a furnace such as an autoclave, an oven or other thermal-processing equipment while under pressure to fuse the material stack members (e.g., 40, 42, and, optionally, 71) together and form a consolidated TPC structure 86. It is contemplated, however, that the material stack 78 may be consolidated using other methods to provide the consolidated TPC structure 86.

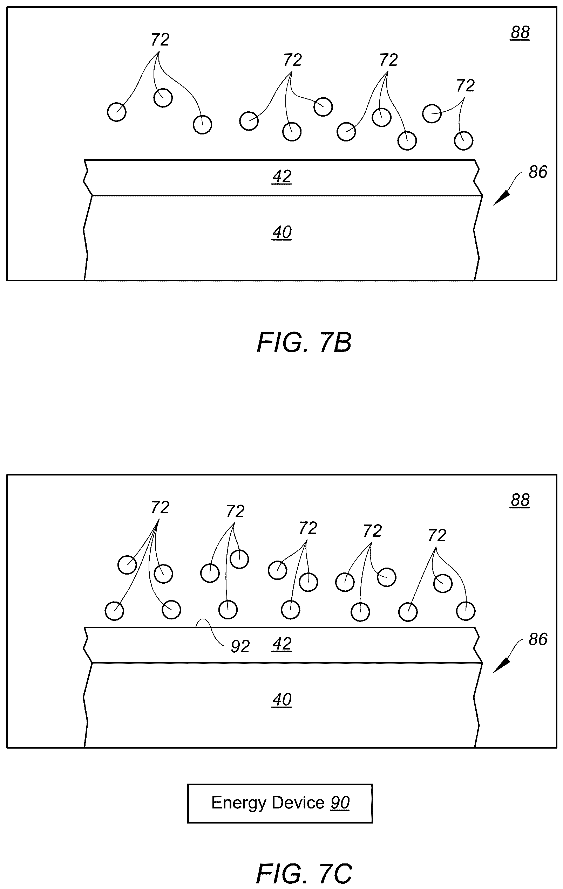

In step 510, referring to FIGS. 7A-D, the TF layer 44 is deposited with the consolidated TPC structure 86 using a plasma treatment process. During the plasma treatment process, the consolidated TPC structure 86 is arranged within a plasma treatment chamber 88 (see FIG. 7A). The plasma treatment chamber 88 may be configured with or otherwise include a vacuum to evacuate air within the chamber 88. Once the air is evacuated within the plasma treatment chamber 88, TF material 72 may be introduced into the plasma treatment chamber 88 in the gaseous phase (see FIG. 7B). Energy may then be applied to the plasma treatment chamber 88 using an energy device 90 (e.g., electromagnetic energy emitting device, heating device, etc.) to ionize the TF material 72, which may be deposited onto an exterior surface 92 of the consolidated TPC structure 86 (see FIG. 7C). Once ionized, the TF material 72 will bond to the consolidated TPC structure 86 (e.g., the TSP layer or the resin film layer 71) as the TF layer 44, increasing the surface energy of the consolidated TPC structure 86 (see FIG. 7D).

In step 512, referring to FIG. 8, the paint layer 46 is applied to the consolidated TPC structure 86 and the TF layer 44 to form the finished aircraft component 38. The paint layer 46 may be applied to an outer layer 94 of the TF layer 44 as one or more painted layers (e.g., primer layer, topcoat layer, etc.). The applied paint layer 46 exhibits increased adhesion with the consolidated TPC structure 86 through the increases surface energy of the TF layer 44.

The TF layer of the present disclosure increases the surface energy of the aircraft component, enhancing wettability and adhesive properties thereof. The aircraft component including the TF layer of the present disclosure thereby improves adhesion of the paint layer to the consolidated TPC structure 86. During testing, consolidated TPC bodies including the plasma treated TF layer increased surface energy and wettability to decrease contact angles from 80 degrees to less than 30 degrees. In addition, aircraft components including the plasma treated TF layer exhibited a shear strength more than five times (5x) that untreated aircraft component structures.

While the principles of the disclosure have been described above in connection with specific apparatuses and methods, it is to be clearly understood that this description is made only by way of example and not as limitation on the scope of the invention, which is defined by the claims. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present disclosure is intended to be dedicated to the public regardless of whether the element, component, or method step is explicitly recited in the claims. As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof, that fall within the scope of the claims. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present invention even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present disclosure are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation and the scope of the invention is defined by the claims.

## Claims

1. A formation method, comprising:
providing (502, 504) a thermoplastic composite, TPC, skin and a lightning strike protection, LSP, layer, the LSP layer comprising LSP material;
arranging (506) the TPC skin with the LSP layer on a tool to provide a material stack;
consolidating (508) the material stack to form a consolidated TPC structure; and
depositing (510) a thin film, TF, layer on the consolidated TPC structure using a plasma treatment process, the TF layer including a TF material comprising an amine functional group or an epoxy functional group.

2. The formation method of claim 1, wherein the TPC skin comprises thermoplastic material and fiber reinforcement embedded within the thermoplastic material of the TPC skin.

3. The formation method of claim 1 or 2, wherein the LSP layer comprises the LSP material embedded within a thermoplastic matrix and/or wherein the LSP material comprises a metal foil or a metal mesh.

4. The formation method of claim 1 or 2, wherein
the LSP layer comprises a second thermoplastic material; and
the LSP material comprises a plurality of interconnected conductive elements embedded within the second thermoplastic material.

5. The formation method of any preceding claim, wherein
the consolidated TPC structure comprises the LSP layer bonded to the TPC skin.

6. The formation method of any preceding claim, wherein the deposited TF layer increases a surface energy of the consolidated TPC structure.

7. The formation method of any preceding claim, wherein the TF material further comprises silicon, or wherein the TF material comprises at least one of: an epoxy, an epoxy functional siloxane or an amine functional siloxane, and optionally wherein the TF material consists of at least one of:
glycidyl methacrylate;
N,N-Digylcidyl-4-glycidyloxyaniline;
N-(3-Trimethoxysilylpropyl) diethylenetriamine; or
(3-Aminopropyl) triethoxysilane.

8. The formation method of any preceding claim, wherein the depositing the TF layer on the consolidated TPC structure using the plasma treatment process further comprises:
arranging the consolidated TPC structure within a plasma treatment chamber;
introducing gaseous TF material into the plasma treatment chamber; and
ionizing the gaseous TF material to bond the TF material onto the consolidated TPC structure; and
optionally wherein
the ionizing the gaseous TF material comprises applying an energy source to the plasma treatment chamber.

9. The formation method of any preceding claim, further comprising:
providing a resin film layer; and
arranging the resin film layer on the LSP layer to provide the material stack;
wherein the LSP layer is arranged vertically between TPC layer and the resin film layer.

10. The formation method of any preceding claim, further comprising:
applying (512) a paint layer on the TF layer to provide an aircraft component.

11. The formation method of any preceding claim, wherein
the consolidated TPC structure includes the LSP layer arranged over the TPC skin; and
the TF layer is deposited over the LSP layer with the LSP layer between the TF layer and the TPC skin.

12. A method of forming an aircraft component, comprising:
providing a thermoplastic composite, TPC, skin, a lightning strike protection, LSP, material, and a resin film layer;
arranging the TPC skin on a tool;
depositing the LSP material onto the TPC skin and the resin film layer on the LSP layer to form a material stack with the LSP material between the TPC skin and the resin film layer;
consolidating the material stack to provide a consolidated TPC structure; and
depositing a thin film, TF, layer on the consolidated TPC structure using a plasma treatment process, the TF layer including a TF material comprising an epoxy, an epoxy functional siloxane or an amine functional siloxane.

13. The method of claim 12, wherein the depositing the thin film layer on the consolidated TPC structure using the plasma treatment process further comprises:
arranging the consolidated TPC structure within a vacuum chamber;
introducing gaseous TF material into the vacuum chamber; and
ionizing the gaseous TF material using an energy source to bond the TF material onto the consolidated TPC structure.

14. The method of claim 12 or 13, further comprising:
applying a paint layer on the TF layer to provide the aircraft component.

15. A formation method, comprising:
providing a thermoplastic composite, TPC, skin and a lightning strike protection, LSP, material comprising metal mesh or metal foil;
arranging the TPC skin with the LSP material to provide a material stack;
consolidating the material stack to provide a consolidated TPC structure;
arranging the consolidated TPC structure within a plasma treatment chamber;
introducing gaseous TF material into the plasma treatment chamber;
ionizing the gaseous TF material using an energy source to bond TF material onto the consolidated TPC structure, the TF material comprising an amine functional group with silicon or an epoxy functional group; and
applying a paint layer on the consolidated TPC structure with the bonded TF material to form an aircraft component.
